# EUROPEAN PATENT APPLICATION

(11) **EP 3 054 465 A1**
(43) Date of publication of application: **10.08.2016**
(21) Application number: 15153978.0
(22) Date of filing: 05.02.2015
(51) Int. Cl.: H01F 27/28, H01F 27/34, H01F 37/00, H03H 7/01, H02M 1/12

(54) **Passive low-pass filter and current limiter with a passive low-pass filter**

(71) Applicant: ABB Technology AG, 8050 Zürich (CH)
(72) Inventor: Wojda, Rafal, 31-038 Kraków (PL); Jacukowicz, Rafal, 31-038 Kraków (PL); Paatero, Esa-Kai, 6648 Minusio (CH); Polit, Aleksander, 31-038 Kraków (PL); Boratyn, Arkadiusz, 31-038 Kraków (PL)
(74) Representative: Kock, Ina

(57) **Abstract**

A passive low-pass filter (24, 34) for reducing transients in the electrical output signal of an electrical device (23, 33) having a low operating frequency in the range of 0 to 400 Hz contains at least one multilayer foil inductor (L1, L2, L3). The multilayer foil inductor comprises a core made of a material with relative magnetic permeability equal to or greater than 1 (2), and a multilayer foil winding (3, 11) made of a conductive foil material (19) which is wound with at least two overlapping turns around at least a part (6) of the core (2) and which is connected in series to an output terminal (27, 40, 41) of the electrical device, wherein each of the turns is separated from an adjacent turn by an insulating material which is at least in parts thinner than the thickness (18) of a single layer of the conductive foil material (19).

## Description

The invention relates to a passive low-pass filter for reducing transients in the electrical output signal of an electrical device having a low operating frequency" as well as to a current limiter containing the passive low-pass filter and a power supply containing the current limiter and the passive low-pass filter, wherein the power supply is preferably a direct current (DC) uninterruptible power supply (UPS).

Passive low-pass filters are commonly used to block higher-frequency signals, while letting low-frequency signals pass. The term "passive" refers to the passive electrical components being used in the filter, namely resistors, inductors and capacitors. Opposed to that, "active" filters contain active components such as operational amplifiers or various kinds of transistor based active switches. Active filters are able to amplify their input signal, i.e. they can give the signals amplitude a boost; while the amplitude of the output signal of a passive filter is rarely larger than that of the input signal.

Low-pass filtering is in particular required when it is to be ensured that a DC or low-frequency output signal of a power supply is freed of unwanted noise and of higher-frequency harmonics generated by switching processes in the power supply, wherein the term "low-frequency" includes frequencies from zero to 400 Hz, in particular DC or 50 Hz or 60 Hz or 400 Hz. Conventional output filters are designed in order to achieve a high quality factor in a wide frequency range. This is due to common utilization of a single-layer inductor, which along with filtering capacitors may inject unwanted self-resonant ringing frequencies into a dc or low frequency system. Nowadays, power supplies are often implemented as switching-mode power supplies including a switching regulator. From DE 102 32 677 A1, it is known that such a switching regulator can be provided with a current limiting function and active harmonic filtering. However, the usage of active components for the filtering results in an increased effort during designing and production of the filter circuit and corresponding control circuitry.

Accordingly, it is an object of the present invention to provide a low-pass filter for reducing transients in the electrical output signal of an electrical device operating at low frequencies with which the effort during design and production can be reduced. In particular, it is an object to find a low-pass filter for the current limiter of a power supply.

This objective is achieved by a passive low-pass filter and a current limiter according to the independent claims.

According to the invention, a passive low-pass filter is provided, which contains at least one multilayer foil inductor which comprises a core made of a material with relative magnetic permeability equal to or greater than 1 and a multilayer foil winding made of a conductive foil material, where the conductive foil material is wound with at least two overlapping turns around at least a part of the core, wherein each of the turns is separated from an adjacent turn by an insulating material which is at least in parts thinner than the thickness of a single layer of the conductive foil material, and where the resulting multilayer foil winding is connected in series to an output terminal of the electrical device

The basic idea behind the invention is to regard the proximity effect occurring in a coiled winding not as a disadvantage, but instead to make use of it advantageously. The proximity effect is caused by the magnetic field induced by a current flowing in the same direction through adjacent conductors. It results in a reduction of the effective cross-sectional area of the current flow, due to the fact that the current is concentrated in the areas of the conductor furthest away from the adjacent conductors. As a result, power losses in the conductors are increased which is commonly regarded as an unwanted effect.

The inventors have now recognized that a certain feature of the proximity effect might prove to be of advantage in low-pass filters, this feature being the frequency-dependency of the proximity effect. With increased frequency, the proximity effect intensifies. Further, the proximity effect increases with reduced proximity of the adjacent conductors. Simulations and experiments proved that in a multilayer foil inductor comprising a foil winding of conductive foil material which is wound in at least two overlapping turns around a core, with the turns being separated from each other by an insulating material which is at least in parts thinner than the thickness of a single layer of the conductive foil material, the AC (alternative current) resistance of the inductor is increased to such an extent that it measurably increases the damping of high frequency current oscillations, i.e. reduces the quality factor at these frequencies compared to a conventional wire-wound inductor.

Accordingly, a passive low-pass filter is proposed which includes at least one of the above described multilayer foil inductors in order to attenuate higher frequencies occurring in the input signal to the passive low-pass filter and thereby to achieve a damping of amplitudes and a reduction of time periods during which transients occur. This damping effect is achieved based on the frequency dependent behavior of losses of the filter structure which is a result of the controlled proximity effect accomplished by designing the winding in the above described way. Compared to the active low-pass filters, the number of elements required to achieve the same functionality is reduced, and the general effort for designing and producing the filter is reduced as well significantly.

The passive low-pass filter may be part of a current limiter, preferably a current limiter containing at least one actively controlled electronic switching component. Due to the active switching, considerable harmonics are produced in the current signal. When the above multilayer foil inductor or inductors are used in the low-pass filter of the current limiter, a significant reduction in the current stresses of the at least one actively controlled switches can be observed. Further, the length of the time response of the current limiter to sudden events, such as overload currents or short circuits, is reduced.

The current limiter may be part of a power supply for providing an electrical output signal with a low nominal frequency in the range of 0 to 400 Hz. In particular, the power supply may be a DC power supply, such as an uninterruptible DC power supply. A preferred output voltage level for the DC power supply is of the order of 380 V, but in general, the multilayer foil inductor may be adapted to be used in a passive low-pass filter at a higher or lower voltage level as well.

Preferably, the passive low-pass filter is an inductor-capacitor-network (LC-network). In such a filtering network, the usage of the multilayer foil inductor with a magnetic core made of a material with relative magnetic permeability equal to or greater than 1 results in a significant reduction of the current stresses on the filtering capacitor or capacitors.

In a specific embodiment, the LC-network contains at least two inductors, the windings of which are both connected in series to an output terminal of the electrical device. In other words, the LC-network takes the form of an LCL-filter. LCL-filters are used more and more at the output side of power sources, in order to reduce undesired current harmonics.

The invention and its embodiments will become even more apparent from the example and its embodiments described below in connection with the appended drawings which illustrate:
- Fig. 1: a multilayer foil inductor with a core made of a material with relative magnetic permeability equal to or greater than 1 and four overlapping turns of the winding;
- Fig. 2: a multilayer foil inductor with a core made of a material with relative magnetic permeability equal to or greater than 1 and eight overlapping turns of the winding;
- Fig. 3: the outer shape of the core of the inductors of Figs. 1 and 2;
- Fig. 4: the outer shape of a core former to be inserted in the core of Fig. 3;
- Fig. 5: an equivalent circuit diagram of the real inductors of Fig. 1 and 2;
- Fig. 6: a circuit diagram of an LCL filter;
- Fig. 7: a step response of a conventional LCL-filter compared to the step response of an LCL-filter with the multilayer foil inductors of Figs. 1 and 2;
- Fig. 8: a schematic diagram of a power supply with DC source and current limiter, connected to a DC load;
- Fig. 9: a circuit diagram of the power supply of Fig. 8.

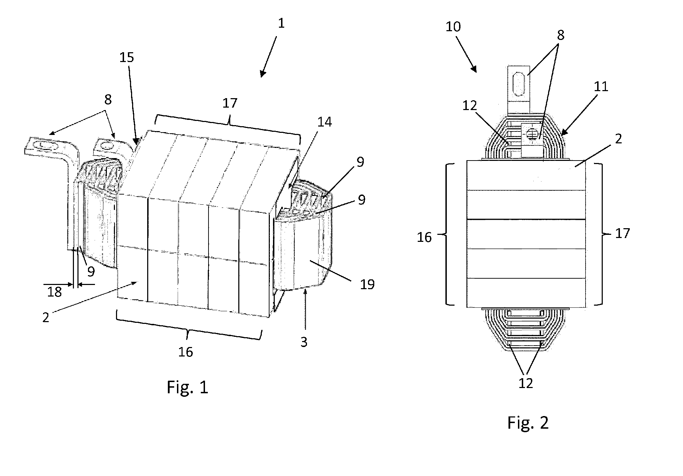

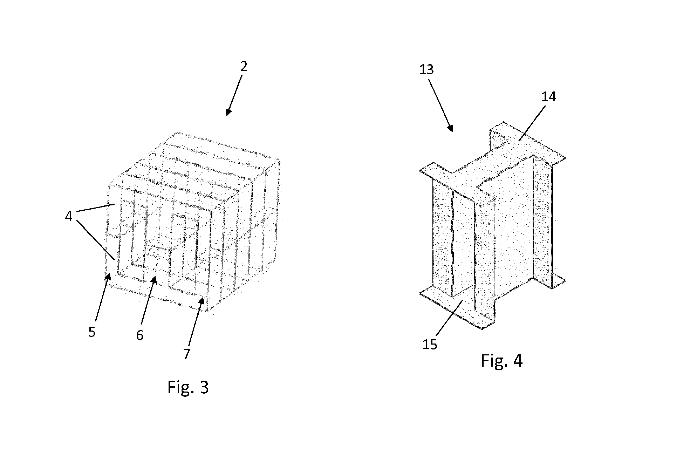

Fig. 1 shows a multilayer foil inductor 1 which comprises a core 2 made of material with relative magnetic permeability equal to or greater than 1 , which is made of a magnetic compound. The multilayer foil inductor 1 further comprises a multilayer foil winding 3 made of a conductive foil material 19 wound in four overlapping turns, thereby creating four layers. The core 2 is arranged in the form of a pair of E-shapes 4 opposing each other, resulting in three parallel yokes 5, 6, 7 (see Fig. 3). The conductive foil material is wound around the middle yoke 6. Two busbars 8 are provided, each one electrically connected to one of the two ends of the multilayer foil winding 3, wherein the multilayer foil inductor 1 may be connected in series to respective output terminals of an electrical device via the busbars 8.

As can be seen from Fig. 3, the core 2 is a stacked core containing in this example five pairs 4 of the opposing E-shapes being fastened to each other, preferably being glued together. The magnetic compound of the core made of a material with relative magnetic permeability equal to or greater than 1 (2) is preferably made of iron and silicon. But any other magnetic compound applicable for a core made of a material with relative magnetic permeability equal to or greater than 1 may be used as well, depending on the specific technical requirements, concerning for example the saturation level, operating temperature, or inductance stability w.r.t. DC or AC bias. The magnetic compound may for example contain, besides iron, nickel, aluminum, molybdenum, silicon, cobalt, manganese, zinc, and/or boron. Having in mind the objective of reducing the effort during design and production, core 2 may be chosen to be a powdered core, rather than a ferrite or a tape wound core.

The multilayer foil winding 3 is made of copper foil or aluminum foil.

In the example of Fig. 1, the multilayer foil winding 3 contains four layers of conductive foil material 19, with spacers 9 placed between the turns or layers in areas of the multilayer foil winding 3 which are not surrounded by the core 2, in order to facilitate heat dissipation. In the areas 16 and 17 of the multilayer foil winding 3 which are surrounded by the core 2, an insulating material is placed between the turns or layers, which insulating material is at least in these areas 16, 17 thinner than the thickness 18 of a single layer of the conductive foil material 19.

As a result of this design, the multilayer foil winding 3 of Fig. 1 has an elongated form, with a height equal to the width of conductive foil material 19. The elongated form has two longitudinal sides which are connected by two polygonal ends. The polygonal ends result from the placing of the spacers 9 between the layers. On each of the longitudinal sides (16, 17), the insulating material arranged between the layers is thinner than the thickness 18 of the conductive foil material 19. In this way, the proximity effect is actively made use of by increasing the AC resistance of the inductor 1 considerably, leading to a significant reduction of the quality factor at high frequencies.

The example of Fig. 2 shows generally the same design for a multilayer foil inductor 10 as in Fig. 1, with the difference that the multilayer foil winding 11 is made of eight turns of the conductive foil material 19, having spacers 12 placed after every second turn, again to facilitate heat dissipation.

In Fig. 4, the outer shape of a coil former 13 is shown. When mounted inside the multilayer foil inductors 1 or 10, the coil former 13 surrounds the middle yoke 6 of the core 2, with its double T-shaped front ends 14, 15 lying flat against the front ends of the core 2 (see Fig. 1).

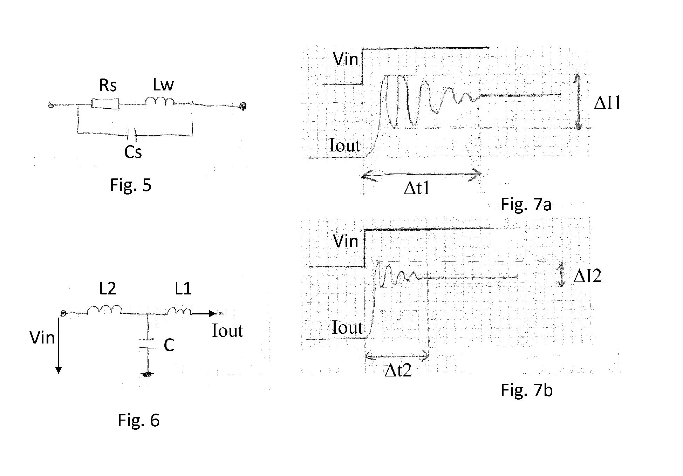

An equivalent electrical circuit diagram of the inductors of Fig. 1 and 2, which is valid to the first self-resonant frequency, is shown in Fig. 5. It shows the following three main elements, representing characteristic values of the inductors, namely the inductance of their winding Lw, their series resistance Rs and their shunt capacitance Cs. As discussed above, the basic idea of the present invention is to make use of the proximity effect, which is particularly strong in multilayer inductor windings with multiple turns, as in the inductors 1 and 10 of Figs. 1 and 2. Due to the proximity effect, the series resistance Rs increases considerably with increasing operating frequency, so that the inductors may be advantageously applied in a passive low-pass filter for reducing the quality factor of the low-pass filter at higher frequencies, compared to low-pass filters with conventional wire-wound inductors.

An example passive low-pass filter is shown in Fig. 6, depicting an LCL-filter which consists of two series-connected inductors L1, L2 and a shunt connected capacitor C, wherein the capacitor C is shunt-connected at a connecting point between the two series-connected inductors L1, L2.

For such an LCL-filter, a step response of the output current lout to a step in the input voltage Vin was simulated. Fig. 7a shows the step response for an LCL-filter with inductors L1 and L2 being conventional wire-wound inductors, and Fig. 7b shows the step response for an LCL-filter with inductor L2 being the multilayer foil inductor 10 of Fig. 2, and inductor L1 being the multilayer foil inductor 1 of Fig. 1. As can be seen, both the amplitude Δl2 of the current oscillations as well as the time length Δt2 for attenuating the current oscillations are considerably smaller for the multilayer foil inductors, compared to the respective Δl1 and Δt1 for the wire-wound inductors.

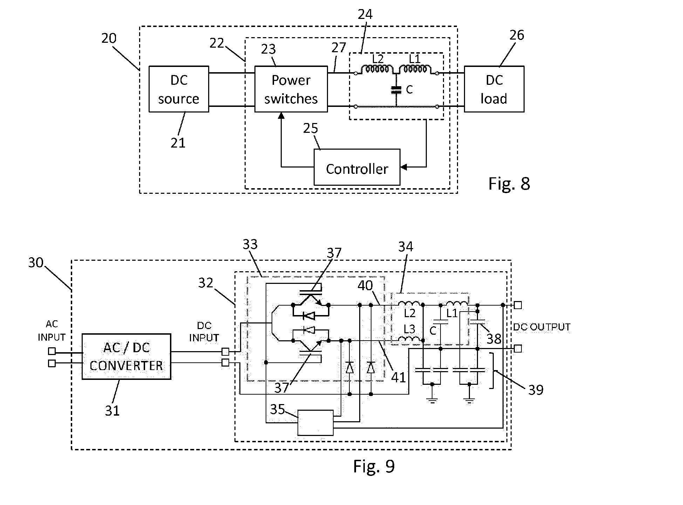

Such an LCL-filter can advantageously be applied to the current limiter of a low-frequency power supply, in particular a DC power supply. In Fig. 8, there is depicted a schematic diagram of a DC power supply 20 comprising a DC source 21 and a current limiter 22 with filtered output, wherein the current limiter 22 comprises a power switching circuit 23 and an LCL-filter 24 for filtering the output signal from the power switching circuit 23. The DC power supply 20 further comprises a controller 25 for controlling output voltage and output current of the DC power supply 20. The output terminals of the LCL-filter 24 and thereby the output terminals of the DC power supply 20 are connected to a DC load 26. The LCL-filter 24 of Fig. 8 corresponds to the LCL-filter of Fig. 7, i.e. multilayer foil inductor L1 is designed according to Fig. 1 and multilayer foil inductor L2 is designed according to Fig. 2. Both inductors are connected in series to an output terminal 27 of the power switching circuit 23.

In Fig. 9, a more detailed circuit diagram of a DC power supply 30 is shown, having the same general structure as the DC power supply of Fig. 8. The DC power supply 30 is designed to provide an output voltage of 380 V. The DC source 31 is implemented as an AC/DC converter; the power switching circuit 33 contains as main switching elements two IGBTs 37; and in addition to the LCL-filter 34, a smoothing capacitor 38 is provided across the output terminals of the LCL-filter 34 for attenuating any remaining voltage ripples. Even further, filtering capacitors 39 are connected one in shunt and one in series, to the capacitor C of the LCL-filter 34 and to the smoothing capacitor 38, respectively. The LCL-filter 34 contains in addition to the load-side multilayer foil inductor L1, which is designed according to Fig. 1, and to the IGBT-side multilayer foil inductor L2, which is designed according to Fig. 2, a further IGBT-side multilayer foil inductor L3, which is also designed according to Fig. 2. While inductors L1 and L2 are connected in series to the upper one of the output terminals 40 of the power switching circuit 33, inductor L3 is connected in series to the lower one of these output terminals 41. A controller 35 controls again the output voltage and output current of the DC power supply 30.

The current limiter 22, 32 is specifically needed to limit the current in case of unexpected outside events, such as occurrence of an overload or a short-circuit at the output of the DC power supply 20, 30. In normal operation mode of the DC power supply 20, 30, the power switches (37) of the power switching circuit 23, 33 are in their ON-state, so that the DC voltage and DC current delivered from the DC source 21, 31 are directly filtered by the LCL-filter 24, 34.

In case of an overload or a short-circuit at the DC output side of the DC power supply 20, 30, the current drawn towards the DC output starts to increase suddenly and heavily, to which the controller 25, 35 reacts by temporarily and repeatedly switching OFF and ON again the power switches of the power switching circuit 23, 33, so that the resulting average value of the output current is decreased. This operational mode may also be called "chopping mode". By changing into the chopping mode, the power switches of the power switching circuit 23, 33 as well as the active components in the AC/DC converter of DC source 31 are protected from being destroyed by overcurrent.

However, the consecutive switching OFF and ON of the power switches in the current limiter causes the LCL-filter 24, 34 to oscillate, with the amplitude increasing at frequencies close to the self-resonant frequency of the LCL-filter. This results in the generation of high-frequency harmonic current components which need to be attenuated again. In the example of Fig. 9, the high-frequency range to be attenuated starts approximately above 5 kHz.

By utilizing the multilayer foil inductors L1, L2 and L3, the series resistance Rs of the inductors in the LCL-filter is increased for these high-frequency current components, compared to LCL-filters with conventional wire-bound inductors. This is due to the proximity effect. Thus, the quality factor of the LCL-filter 24, 34 is decreased at these higher frequencies, so that a higher damping of the resulting current oscillations, and a faster response of the current limiter 22, 32 to unexpected outside events is achieved. This means that the transients in the filter response of the LCL-filter to sudden changes in the input signal are reduced considerably, so that the current stresses on the capacitor C of the LCL-filter, on the smoothing capacitor 38, as well as on the power switches of the power switching circuit 23, 33 are reduced significantly. This is a novel approach to utilization of the proximity effect, which until now has been treated as unwanted. The proposed approach is a step towards increasing the stability of DC or low frequency systems

## Claims

1. Passive low-pass filter (24, 34) for current limiting devices for damping an amplitude and/or reducing a time period of voltage and current oscillations in the electrical output signal of an electrical device (23, 33) having a low nominal electrical output signal operating frequency in the range of 0 to 400 Hz, the passive low-pass filter (24, 34) containing at least one multilayer foil inductor (L1, L2, L3) which comprises
• a core made of a material with relative magnetic permeability equal to or greater than 1 (2) made of a magnetic compound,
• a multilayer foil winding (3, 11) made of a conductive foil material (19) which is wound with at least two overlapping turns around at least a part (6) of the core (2) and which is connected in series to an output terminal (27, 40, 41) of the electrical device, wherein each of the turns is separated from an adjacent turn by an insulating material which is at least in parts thinner than the thickness (18) of a single layer of the conductive foil material (19).

2. Passive low-pass filter according to claim 1, wherein the passive low-pass filter (24, 34) is an LC-network.

3. Passive low-pass filter according to claim 2, wherein the LC-network contains at least two inductors (L1, L2), the windings of which are both connected in series to an output terminal (27, 40) of the electrical device.

4. Passive low-pass filter according to any of the previous claims, wherein the core (2) of the at least one multilayer foil inductor (1) is arranged in the form of a pair of E-shapes (4) opposing each other, resulting in three parallel yokes (5, 6, 7), and wherein the foil winding (3, 11) is wound around the middle yoke (6).

5. Passive low-pass filter according to claim 4, wherein the core (2) is a stacked core containing at least two pairs of the opposing E-shapes (4) being fastened to each other.

6. Passive low-pass filter according to any of the previous claims, wherein the magnetic compound of the core (2) contains a combination of at least two of iron, silicon, nickel, aluminum, molybdenum, cobalt, manganese, zinc, and boron.

7. Passive low-pass filter according to any of the previous claims, wherein the multilayer foil winding (3, 11) is made of copper or aluminum.

8. Passive low-pass filter according to any of the previous claims, wherein the multilayer foil winding (3, 11) is made of at least four turns.

9. Current limiter (22, 32) with a passive low-pass filter (24, 34) for reducing transients in the electrical output signal of an electrical device (20, 30) having a low operating frequency in the range of 0 to 400 Hz, the passive low-pass filter (24, 34) being arranged according to any of the previous claims 1 to 8.

10. Current limiter according to claim 9, wherein the current limiter (22, 32) contains at least one actively controlled electronic switching component (37).

11. Power supply (20, 30) for providing an electrical output signal with a low nominal frequency in the range of 0 to 400 Hz, the power supply (20, 30) comprising a current limiter (22, 32), wherein the current limiter contains a passive low-pass filter according to any of the previous claims 1 to 8.

12. Power supply according to claim 11, wherein the power supply is an uninterruptible DC power supply.
